(19) Europäisches Patentamt
European Patent Office
Office européen des brevets

(11) **EP 4 780 164 A1**

(12) **EUROPEAN PATENT APPLICATION**
published in accordance with Art. 153(4) EPC

(43) Date of publication:
**22.07.2026 Bulletin 2026/30**

(21) Application number: **24865133.3**

(22) Date of filing: **07.08.2024**

(51) International Patent Classification (IPC):
*H10D 84/03* (2025.01)    *H10D 84/00* (2025.01)

(86) International application number:
**PCT/JP2024/028310**

(87) International publication number:
**WO 2025/057627 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.09.2023 JP 2023147508**

(71) Applicant: **Sony Semiconductor Solutions
Corporation
Atsugi-shi, Kanagawa 243-0014 (JP)**

(72) Inventor: **AKIMOTO, Tetsuya
Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **HIGH-FREQUENCY CIRCUIT AND HIGH-FREQUENCY CIRCUIT MODULE**

(57)    A high-frequency circuit according to the present technology includes: a base substrate; an insulating layer; a first terminal; a circuit element; a second terminal; and a bypass via. The base substrate is electrically connected to a ground, and is made of a semiconductor material. The insulating layer is provided to the base substrate. The first terminal is provided to the insulating layer, and a high-frequency signal in a predetermined high-frequency band is input to the first terminal. The circuit element is provided to the insulating layer, and is electrically connected to the first terminal. The second terminal is provided to the insulating layer, and is electrically connected to the circuit element, and the high-frequency signal that is input to the first terminal and that flows through the circuit element is output from the second terminal. The bypass via electrically connects the first terminal or the second terminal and the base substrate to each other, and forms a bypass path for a low-frequency signal in a frequency band lower than the predetermined high-frequency band.

FIG.1

**Description**

Technical Field

The present technology relates to high-frequency circuits and high-frequency circuit modules.

Background Art

Patent Literature 1 discloses a signal transmission member that is arranged between an RF (Radio Frequency) circuit and an antenna element. This signal transmission member includes a signal transmission line and an electrostatic-discharge protection element, and provides an effect of electrostatic-discharge protection.

Patent Literature 2 discloses a printed circuit board that utilizes a spark gap provided between a ground pattern and an electrostatic-discharge protection body as an ESD (Electro Static Discharge) protection path.

Citation List

Patent Literature

Patent Literature 1: Japanese Patent Application Laid-open No. 2019-103125
Patent Literature 2: Japanese Patent Application Laid-open No. 2015-50455

Disclosure of Invention

Technical Problem

In designing high-frequency circuits as described above, countermeasures against high-voltage surges such as electrostatic discharge are an important issue.

In view of such circumstances, it is an object of the present technology to provide a high-frequency circuit and a high-frequency circuit module that are capable of implementing circuit protection against high-voltage surges while suppressing degradation of circuit characteristics.

Solution to Problem

In order to achieve the above-mentioned object, a high-frequency circuit according to an embodiment of the present technology includes: a base substrate; an insulating layer; a first terminal; a circuit element; a second terminal; and a bypass via.

The base substrate is electrically connected to a ground, and is made of a semiconductor material.

The insulating layer is provided to the base substrate.

The first terminal is provided to the insulating layer, and a high-frequency signal in a predetermined high-frequency band is input to the first terminal.

The circuit element is provided to the insulating layer, and is electrically connected to the first terminal.

The second terminal is provided to the insulating layer, and is electrically connected to the circuit element, and the high-frequency signal that is input to the first terminal and that flows through the circuit element is output from the second terminal.

The bypass via electrically connects the first terminal or the second terminal and the base substrate to each other, and forms a bypass path for a low-frequency signal in a frequency band lower than the predetermined high-frequency band.

In this high-frequency circuit, the first terminal or the second terminal and the base substrate are electrically connected to each other with the bypass via. This bypass via forms the bypass path for the low-frequency signal. As a result, while suppressing degradation of circuit characteristics, protection against electrostatic discharge can be implemented.

The high-frequency circuit may include, as the bypass via, at least one of

a first bypass via which electrically connects the first terminal and the base substrate to each other, and which forms a bypass path for the low-frequency signal that is input to the first terminal, or
a second bypass via which electrically connects the second terminal and the base substrate to each other, and which forms a bypass path for the low-frequency signal that is input to the second terminal.

The high-frequency circuit may include the first bypass via as the bypass via.

In this case, for the high-frequency signal, an impedance of a path from the first terminal to the second terminal through the circuit element may be lower than an impedance of a path from the first terminal to the ground through the first bypass via and the base substrate.

Meanwhile, for the low-frequency signal, the impedance of the path from the first terminal to the second terminal through the circuit element may be higher than the impedance of the path from the first terminal to the ground through the first bypass via and the base substrate.

The high-frequency circuit may include the second bypass via as the bypass via.

In this case, for the high-frequency signal, an impedance of a path from the second terminal to the first terminal through the circuit element may be lower than an impedance of a path from the second terminal to the ground through the second bypass via and the base substrate.

Meanwhile, for the low-frequency signal, the impedance of the path from the second terminal to the first terminal through the circuit element may be higher than the impedance of the path from the second terminal to the ground through the second bypass via and the base substrate.

The high-frequency circuit may include both the first bypass via and the second bypass via.

The first terminal, the circuit element, and the second terminal may be provided to the insulating layer to be separated from the base substrate.

The bypass via may extend from the insulating layer to the base substrate, and may be connected to the base substrate.

The second terminal may function also as a terminal to which the high-frequency signal is input.

In this case, the first terminal may function also as a terminal from which the high-frequency signal that is input to the second terminal and that flows through the circuit element is output.

The predetermined high-frequency band may be a frequency band of 1 GHz or higher.

The circuit element may be a transistor.

The base substrate may be a silicon substrate.

The high-frequency circuit may further include a first connection member which is provided to the insulating layer, and which electrically connects the first terminal and the circuit element to each other.

In this case, the first bypass via may electrically connect the first connection member and the base substrate to each other.

The high-frequency circuit may further include a second connection member which is provided to the insulating layer, and which electrically connects the second terminal and the circuit element to each other.

In this case, the second bypass via may electrically connect the second connection member and the base substrate to each other.

The high-frequency circuit may further include:

a ground terminal which is electrically connected to the ground; and
a ground connection portion which electrically connects the ground terminal and the base substrate to each other.

A high-frequency circuit module according to an embodiment of the present technology includes one or more high-frequency circuits.

The one or more high-frequency circuits each include:

the base substrate;
the insulating layer;
the first terminal;
the circuit element;
the second terminal; and
the bypass via.

Brief Description of Drawings

[Fig. 1] A schematic view illustrating an example of a basic configuration of a high-frequency circuit according to an embodiment of the present technology.

[Fig. 2] A diagram showing an equivalent circuit of the high-frequency circuit including signal paths and bypass paths illustrated in in Fig. 1.

[Fig. 3] A graph showing results of electromagnetic-field simulations (temporal variations of voltage to be applied to a circuit element).

[Fig. 4] A graph showing results of electromagnetic-field simulations (frequency characteristics of amounts of current that has flowed through the circuit element).

[Fig. 5] A schematic view illustrating another example of the configuration of the high-frequency circuit according to the present technology.

[Fig. 6] A schematic view illustrating a still another example of the configuration of the high-frequency circuit according to the present technology.

Mode(s) for Carrying Out the Invention

Hereinbelow, embodiments according to the present technology are described with reference to the drawings.

[High-Frequency Circuit]

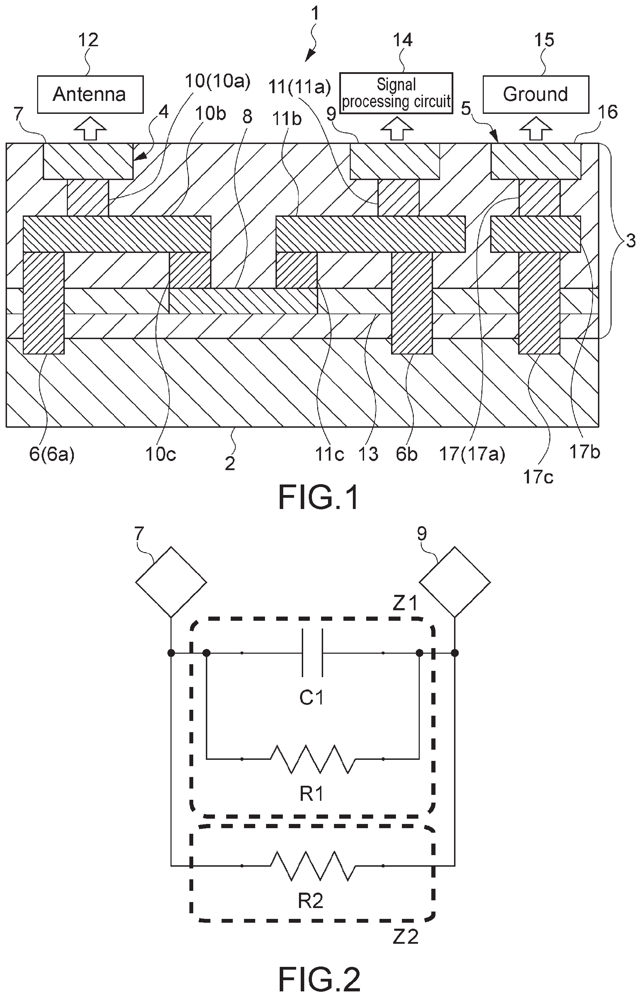

Fig. 1 is a schematic view illustrating an example of a basic configuration of a high-frequency circuit according to an embodiment of the present technology. This high-frequency circuit 1 includes a base substrate 2, an insulating layer 3, a circuit portion 4, a ground connection portion 5, and a bypass via 6.

The base substrate 2 is a substrate that serves as a base for implementing the high-frequency circuit 1, and is made of a semiconductor material. In this embodiment, a silicon substrate is used as the base substrate 2. Alternatively, a semiconductor substrate made of any semiconductor material may be employed.

The insulating layer 3 is laminated on the base substrate 2. In this embodiment, the insulating layer 3 is constituted by forming an SiO (silicon oxide) film on a surface of the base substrate 2. Alternatively, the insulating layer 3 that is made of any material may be employed.

The circuit portion 4 is provided to the insulating layer 3. Herein, the phrase "provided to insulating layer" means arrangement on the surface or inside the insulating layer 3. Thus, the provision of the circuit portion 4 to the insulating layer 3 means that components of the circuit portion 4 are arranged on the surface or inside the insulating layer 3.

Further, in this embodiment, the circuit portion 4 is provided to the insulating layer 3 to be separated from the base substrate 2. In other words, the components of the circuit portion 4 are arranged at positions physically separated from the base substrate 2.

Any method may be employed as a method of forming the circuit portion 4 on the surface or inside the insulating layer 3 so that the circuit portion 4 is separated from the base substrate 2. For example, the circuit portion 4 can be implemented by using SOI (Silicon on Insulator) technology. Specifically, in the insulating layer 3, an insulating layer to be formed on the base substrate 2, and an insulating layer to be formed between the components of the circuit portion 4, the insulating layers being illustrated in in Fig. 1, may be formed in different steps. In addition, these insulating layers may be made of insulating materials different from each other.

As illustrated in Fig. 1, the components of the circuit portion 4 include a first terminal 7, a circuit element 8, and a second terminal 9. In addition, the components of the circuit portion 4 include a first connection member 10 and a second connection member 11. In this embodiment, these components are provided to the insulating layer 3 to be separated from the base substrate 2.

A high-frequency signal in a predetermined high-frequency band is input to the first terminal 7. In the example illustrated in Fig. 1, an antenna pad to be electrically connected to an antenna 12 is configured as the first terminal 7. As a matter of course, alternatively, a terminal to be electrically connected to any element that outputs the high-frequency signal can function as the first terminal 7 according to the present technology. Note that, the high-frequency circuit is also referred to as an RF circuit. In addition, the high-frequency signal is also referred to as an RF signal.

The circuit element 8 is electrically connected to the first terminal 7. In the example illustrated in Fig. 1, a well layer 13 is provided to the insulating layer 3, and the circuit element 8 is configured as a transistor. A specific configuration of the transistor is not limited, and any configuration may be employed. Further, as the circuit element 8, any other element than the transistor may be arranged, or any active element or any passive element may be arranged.

As illustrated in Fig. 1, in this embodiment, the first connection member 10 that electrically connects the first terminal 7 and the circuit element 8 to each other is configured. The first connection member 10 includes a via 10a that is connected to the first terminal 7, a conductive line 10b that is connected to the via 10a, and a via 10c that is connected to the conductive line 10b.

The circuit element 8 is electrically connected to the first terminal 7 by being connected to the via 10c of the first connection member 10. A specific configuration of the first connection member 10 is not limited, and may be freely designed.

The second terminal 9 is electrically connected to the circuit element 8, and outputs the high-frequency signal that is input to the first terminal 7 and that flows through the circuit element 8. In the example illustrated in in Fig. 1, a processing-circuit pad to be electrically connected to a signal processing circuit 14 is configured as the second terminal 9. The signal processing circuit 14 is a circuit that processes the high-frequency signal output from the second terminal 9. As a matter of course, alternatively, a terminal to be electrically connected to any element to which the high-frequency signal is input can function as the second terminal 9 according to the present technology.

In this embodiment, the second connection member 11 that electrically connects the second terminal 9 and the circuit element 8 to each other is configured. The second connection member 11 includes a via 11a that is connected to the second terminal 9, a conductive line 11b that is connected to the via 11a, and a via 11c that is connected to the conductive line 11b.

The via 11c of the second connection member 11 and the circuit element 8 are connected to each other. With this, the second terminal 9 is electrically connected to the circuit element 8. A specific configuration of the second connection member 11 is not limited, and may be freely designed.

In this embodiment, at a time of reception during high-frequency communication utilizing the antenna 12, the high-frequency signal output from the antenna 12 is input to the first terminal 7. The high-frequency signal input to the first terminal 7 is output from the second terminal 9 through the first connection member 10, the circuit element 8, and the second connection member 11. The high-frequency signal output from the second terminal 9 is input to the signal processing circuit 14.

Note that, at a time of transmission during the high-frequency communication utilizing the antenna 12, the high-frequency signal output from the signal processing circuit 14 is input to the second terminal 9. The high-frequency signal input to the second terminal 9 is output from the first terminal 7 through the second connection member 11, the circuit element 8, and the first connection member 10. The high-frequency signal output from the first terminal 7 is input to the antenna 12.

In such a way, at the time of the transmission during the high-frequency communication, the second terminal 9 functions also as a terminal to which the high-frequency signal is input. In addition, the first terminal 7 functions also as a terminal from which the high-frequency signal that is input the second terminal 9 and that flows through the circuit element 8 is output.

The present technology is applicable not only to the case where the high-frequency signal flows only in one direction along a path including the circuit element 8 between the first terminal 7 and the second terminal 9, but also to the case where the high-frequency signal flows in both directions. In other words, the present technology is applicable without limiting the direction (orientation) in which the high-frequency signal flows, and is capable of circuit protection against high-voltage surges such as electrostatic discharge.

Materials of the first terminal 7, the second terminal 9, the first connection member 10 (via 10a, conductive line 10b, and via 10c), and the second connection member 11 (via 11a, conductive line 11b, and via 11c) are not limited, and any conductive material including, for example, metal materials such as copper, and semiconductor materials intended for conduction, such as polysilicon, may be used.

The ground connection portion 5 is configured to connect the base substrate 2 to a ground (reference potential) 15. In the example illustrated in Fig. 1, the ground connection portion 5 includes a ground terminal 16 that is provided to the insulating layer 3, and that is electrically connected to the ground 15. In addition, the ground connection portion 5 includes a ground connection member 17 that electrically connects the ground terminal 16 and the base substrate 2 to each other. In this embodiment, the ground connection member 17 includes a via 17a that is connected to the ground terminal 16, a conductive line 17b that is connected to the via 17a, and a ground via 17c that is connected to the conductive line 17b.

The ground via 17c extends from the insulating layer 3 to the base substrate 2, and is connected to the base substrate 2. With this, the base substrate 2 is connected to the ground 15.

The bypass via 6 electrically connects the first terminal 7 or the second terminal 9 and the base substrate 2 to each other, and forms a bypass path for low-frequency signals in a frequency band lower than the predetermined high-frequency band.

In this embodiment, the bypass via 6 includes a first bypass via 6a that electrically connects the first terminal 7 and the base substrate 2 to each other, and that forms a bypass path for low-frequency signals which are input to the first terminal 7. In addition, the bypass via 6 includes a second bypass via 6b that electrically connects the second terminal 9 and the base substrate 2 to each other, and that forms a bypass path for low-frequency signals which are input to the second terminal 9.

The first bypass via 6a electrically connects the first connection member 10 and the base substrate 2 to each other. In this embodiment, the first bypass via 6a is connected to the conductive line 10b of the first connection member 10. In addition, the first bypass via 6a extends from the insulating layer 3 to the base substrate 2, and is connected to the base substrate 2. With this, the first terminal 7 and the base substrate 2 are electrically connected to each other by the first bypass via 6a.

The second bypass via 6b electrically connects the second connection member 11 and the base substrate 2 to each other. In this embodiment, the second bypass via 6b is connected to the conductive line 11b of the second connection member 11. In addition, the second bypass via 6b extends from the insulating layer 3 to the base substrate 2, and is connected to the base substrate 2. With this, the second terminal 9 and the base substrate 2 are electrically connected to each other by the second bypass via 6b.

Materials of the ground connection portion 5 (ground terminal 16, via 17a, conductive line 17b, and ground via 17c), the first bypass via 6a, and the second bypass via 6b are not limited, and any conductive material including, for example, metal materials such as copper, and semiconductor materials intended for conduction, such as polysilicon, may be used. In addition, methods of forming the ground via 17c, the first bypass via 6a, and the second bypass via 6b that are connected to the base substrate 2 are not limited, and any method may be employed.

[Impedance Design of Paths]

A path in the high-frequency circuit 1 from the first terminal 7 to the second terminal 9 through the circuit element 8 (path extending sequentially through first terminal 7, via 10a, conductive line 10b, via 10c, circuit element 8, via 11c, conductive line 11b, via 11a, and second terminal 9) is referred to as a firth signal path.

The path in the high-frequency circuit 1 from the first terminal 7 to the ground 15 through the first bypass via 6a and the base substrate 2 (path extending sequentially through first terminal 7, via 10a, conductive line 10b, first bypass via 6a, base substrate 2, ground via 17c, conductive line 17b, via 17a, and ground terminal 16) is referred to as a first bypass path.

In the high-frequency circuit 1 according to this embodiment, for high-frequency signals, an impedance of the first signal path is designed to be lower than an impedance of the first bypass path. Meanwhile, for low-frequency signals, the impedance of the first signal path is designed to be higher than the impedance of the first bypass path.

With this, at the time of the reception during the high-frequency communication utilizing the antenna 12, the high-frequency signal output from the antenna 12 is output to the signal processing circuit 14 through the first signal path. Meanwhile, the low-frequency signal to be input to the first terminal 7 is routed to the ground 15 through the first bypass path.

In addition, a path in the high-frequency circuit 1 from the second terminal 9 to the first terminal 7 through the circuit element 8 (path extending sequentially through second terminal 9, via 11a, conductive line 11b, via 11c, circuit element 8, via 10c, conductive line 10b, via 10a, and first terminal 7) is referred to as a second signal path.

A path in the high-frequency circuit 1 from the second terminal 9 to the ground 15 through the second bypass via 6b and the base substrate 2 (path extending sequentially through second terminal 9, via 11a, conductive line 11b, second bypass via 6b, base substrate 2, ground via 17c, conductive line 17b, via 17a, and ground terminal 16) is referred to as a second bypass path.

In the high-frequency circuit 1 according to this embodiment, for the high-frequency signals, an impedance of the second signal path is designed to be lower than an impedance of the second bypass path. Meanwhile, for the low-frequency signals, the impedance of the second signal path is designed to be higher than the impedance of the second bypass path.

With this, at the time of the transmission during the high-frequency communication utilizing the antenna 12, the high-frequency signal output from the signal processing circuit 14 is output to the antenna 12 through the second signal path. Meanwhile, the low-frequency signal to be input to the second terminal 9 is routed to the ground 15 through the second bypass path.

Hereinbelow, the design in which the impedance for the high-frequency signals is lower in the signal path (first signal path / second signal path) than in the bypass path (first bypass path / second bypass path), and in which the impedance for the low-frequency signals is higher in the signal path than in the bypass path is referred to as a circuit-protection impedance design.

Fig. 2 is an explanatory circuit diagram showing a method for implementing the circuit-protection impedance design. A circuit shown in Fig. 2 is an equivalent circuit of the high-frequency circuit 1 including the signal paths and the bypass paths illustrated in in Fig. 1. Correspondence between the equivalent circuit shown in Fig. 2 and the high-frequency circuit 1 illustrated in Fig. 1 is as follows.

R1 ... Resistance value of the signal path including the circuit element 8 between the first terminal 7 and the second terminal 9

C1 ... Capacitance value of the signal path including the circuit element 8 between the first terminal 7 and the second terminal 9

R2 ... Resistance value of the bypass path including the base substrate 2

Note that, the capacitance C1 is defined as a parasitic capacitance value between the conductive line 10b of the first connection member 10 and the conductive line 11b of the second connection member 11 illustrated in in Fig. 1.

An impedance of the signal path including R1 and C1 is denoted by Z1, and an impedance of the signal path including R2 is denoted by Z2. Assuming that the impedance Z1 of the signal path is higher than the impedance Z2 of the bypass path, the following expression (1) is established.

[Math 1]

$$|Z_1| > |Z_2| \quad \cdots \cdots (1)$$

In the equivalent circuit shown in Fig. 2, the impedance Z1 of the signal path and the impedance Z2 of the bypass path are expressed by the following expressions (2) and (3).

[Math 2]

$$Z_1 = \cfrac{1}{\frac{1}{R_1} + j\omega C_1} \quad \cdots \cdots (2)$$

$$Z_2 = R_2 \quad \cdots \cdots (3)$$

By substituting the expressions (2) and (3) into the expression (1), the following expression (4) is obtained.

[Math 3]

$$\cfrac{1}{\left|\frac{1}{R_1} + j\omega C_1\right|} > |R_2|$$

$$\Leftrightarrow \cfrac{1}{\frac{1}{R_1^2} + \omega^2 C_1^2} > R_2^2$$

$$\Leftrightarrow \omega^2 R_2^2 C_1^2 < 1 - \frac{R_2}{R_1}$$

$$\Leftrightarrow \omega < \frac{1}{R_2 C_1}\sqrt{1 - \frac{R_2^2}{R_1^2}} \quad \cdots \cdots (4)$$

When an angular velocity $\omega$ in the expression (4) is rewritten in terms of a frequency f, the following expression (5) is obtained.

[Math 4]

$$f < \frac{1}{2\pi R_2 C_1}\sqrt{1 - \frac{R_2^2}{R_1^2}} \quad \cdots \cdots (5)$$

For electrical signals in a frequency band in which the expression (5) is established, the impedance Z1 of the signal path is higher than the impedance Z2 of the bypass path. In other words, the electrical signals in the frequency band in which the expression (5) is established satisfy the condition that the impedance Z1 of the signal path is higher than the impedance Z2 of the bypass path.

Next, assuming a case where the impedance Z1 of the signal path is lower than the impedance Z2 of the bypass path, an expression in which the direction of the inequality in the expression (1) is reversed is established. When the expression (2) and the expression (3) are substituted into this expression, and is rewritten in terms of the frequency f, the following expression (6) is obtained.
[Math 5]

$$f > \frac{1}{2\pi R_2 C_1} \sqrt{1 - \frac{R_2^2}{R_1^2}} \quad \cdots \cdots \quad (6)$$

For electrical signals in a frequency band in which the expression (6) is established, the impedance Z1 of the signal path is lower than the impedance Z2 of the bypass path. In other words, the electrical signals in the frequency band in which the expression (6) is established satisfy the condition that the impedance Z1 of the signal path is lower than the impedance Z2 of the bypass path.

An upper limit value of the low-frequency signals that are to be routed to the ground 15 through the bypass path is defined as fs. A lower limit value of the high-frequency signals that are to flow through the signal path is defined as fh.

As conditions that the impedance Z1 of the signal path is higher than the impedance Z2 of the bypass path for electrical signals with frequencies lower than the frequency fs, and that the impedance Z1 of the signal path is lower than the impedance Z2 of the bypass path for electrical signals with frequencies higher than the frequency fh, there are two conditions to be expressed by the following expressions (7) and (8).

[Math 6]

$$(\text{Condition 1}) \quad R_1 > R_2 \quad \cdots \cdots \quad (7)$$

$$(\text{Condition 2}) \quad f_s < \frac{1}{2\pi R_2 C_1} \sqrt{1 - \frac{R_2^2}{R_1^2}} < f_h \quad \cdots \cdots \quad (8)$$

With regard to (Condition 1), the resistance value of the signal path is greater than the resistance value of the bypass path. For example, when a transistor in an off-state is used as the circuit element 8, (Condition 1) is highly likely to be satisfied. As a matter of course, alternatively, any configuration in which the resistance value of the signal path is greater than the resistance value of the bypass path may be employed.

With regard to (Condition 2), the high-frequency circuit 1 is configured so that a value of the middle term of the expression (8) is greater than the upper limit value fs of the low-frequency signals that are to be routed to the ground, and is smaller than the lower limit value fh of the high-frequency signals that are to be allowed to flow through the signal path.

For example, the high-frequency circuit 1 is configured by setting the resistance value R1 and the capacitance value C1 of the signal path and the resistance value R2 of the bypass path as appropriate for the lower limit value fh of a predetermined high-frequency signal and the upper limit value fs of a predetermined low-frequency signal so that (Condition 1) and (Condition 2) are satisfied.

This enables implementation of the circuit-protection impedance design in which the signal path is lower in the impedance for the high-frequency signals than the bypass path, and in which the signal path is higher in the impedance for the low-frequency signals than the bypass path.

Note that, the resistance value of the bypass path are defined mainly by a resistance value of the base substrate 2. Thus, also by setting the resistance value of the base substrate 2 as appropriate, it is possible to implement the high-frequency circuit 1 that satisfies both (Condition 1) and (Condition 2).

For example, the signal path is designed to allow the predetermined high-frequency signal to flow therethrough. The high-frequency circuit 1 exemplified in Fig. 1 is fabricated by using the SOI technology from the base substrate 2 having the resistance value that satisfies (Condition 1) and (Condition 2) for the resistance value R1 and the capacitance value C1 of the designed signal path. With this, the high-frequency circuit 1 in which the circuit-protection impedance design is implemented can be easily implemented.

For example, the high-frequency circuit 1 according to the present technology can be implemented also by forming the bypass path (first bypass path / second bypass path) according to the present technology in a high-frequency circuit formed by SOI processes used in the related art.

As a matter of course, the method for implementing the circuit-protection impedance design is not limited to the method described with reference to the equivalent circuit show in Fig. 2. Any other method by which the circuit-protection impedance design can be implemented may be employed.

In addition, a condition under which the circuit-protection impedance design can be implemented for the first signal path and the first bypass path as viewed from the first terminal 7, and a condition under which the circuit-protection impedance design can be implemented for the second signal path and the second bypass path as viewed from the second terminal 9 may be set independently of each other, and the high-frequency circuit 1 may be designed to satisfy both the conditions.

[Frequency Bands of High-Frequency Signals / Low-Frequency Signals]

Frequencies of high-voltage surges such as electrostatic discharge fall within several hundred MHz or lower. Application of such high-voltage surges to the circuit element 8 such as a transistor imposes stress on the circuit element, which causes problems such as characteristic degradation or damage.

In the high-frequency circuit 1 according to the present technology, a frequency band higher than 1 GHz is set as the predetermined high-frequency band, and signals in the frequency band higher than 1 GHz are defined as the high-frequency signals. Meanwhile, signals in a frequency band lower than 1 GHz are defined as the low-frequency signals. Implementation of the circuit-protection impedance design with such frequency settings makes it possible to prevent the application of high-voltage surges to the circuit element 8. With this, circuit protection against high-voltage surges can be implemented.

For example, a 3.7 GHz band, a 4.5 GHz band, and a 28 GHz band, which are communication bands of the fifth-generation mobile communication systems (5G), may be set as the predetermined high-frequency band.

Note that, as long as the circuit-protection impedance design according to the present technology can be implemented, the present technology is applicable without limiting specific frequency bands of the high-frequency signals and the low-frequency signals. Meanwhile, as represented, for example, by (Condition 2) to be expressed by the expression (8), conditions become less stringent as frequencies of the high-frequency signals become higher, which is probably advantageous for implementing the circuit-protection impedance design. Similarly, as frequencies of the low-frequency signals become lower, it probably becomes more advantageous for implementing the circuit-protection impedance design.

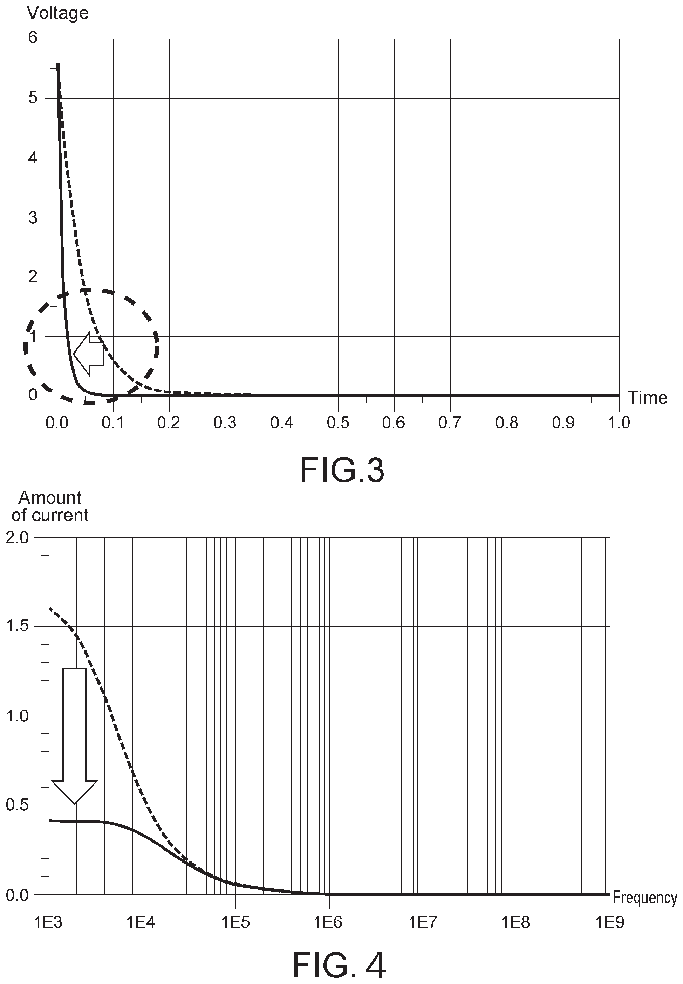

Fig. 3 and Fig. 4 are graphs showing results of electromagnetic-field simulations. In Fig. 3 and Fig. 4, the dashed lines in the graphs show results of the electromagnetic-field simulations for the high-frequency circuit 1 illustrated in in Fig. 1. The solid lines in the graphs show results of the electromagnetic-field simulations for a high-frequency circuit as a comparative example without the bypass via 6.

Fig. 3 is a graph showing a temporal variation of voltage to be applied to the circuit element 8 in response to the application of high-voltage surges as the low-frequency signal to the first terminal 7. In the high-frequency circuit 1 according to the present technology, the voltage to be applied to the circuit element 8 decreases faster than in the high-frequency circuit as the comparative example, specifically, a discharge time is shortened to approximately one-third. This demonstrates that the bypass path function effectively.

Fig. 4 is a graph showing frequency characteristics of amounts of current that has flowed through the circuit element 8 in response to the application of high-voltage surges as the low-frequency signal to the first terminal 7. In frequency bands of 100 KHz (1E5) or less, in the high-frequency circuit 1 according to the present technology, the amount of the current that has flowed through the circuit element is smaller than that in the high-frequency circuit as the comparative example, specifically, an amount of intrusion current is reduced to approximately one-third. This demonstrates that the stress on the circuit element 8 is reduced.

As shown in Fig. 3 and Fig. 4, in the high-frequency circuit 1 according to the present technology, even in the case where high-voltage surges are applied, the voltage decreases quickly, and the amount of the current to flow through the circuit element 8 is small. Thus, an amount of heat to be generated by the circuit element 8 is suppressed. With this, destruction of the circuit element 8 can sufficiently be prevented.

In addition, the high-frequency circuit 1 according to the present technology includes the bypass via 6, and hence circuit protection against high-voltage surges can be implemented. Thus, in comparison with a case where, for example, an electrostatic-discharge protection circuit implemented by capacitive elements is connected, there is substantially no increase in capacitance in high-frequency bands. Thus, the degradation of the circuit characteristics can sufficiently be suppressed.

As described hereinabove, in the high-frequency circuit 1 according to this embodiment, the first terminal 7 or the second terminal 9 and the base substrate 2 are electrically connected to each other with the bypass via 6. This bypass via 6 forms the bypass path for the low-frequency signals. As a result, while suppressing degradation of circuit characteristics, circuit protection against high-voltage surges such as electrostatic discharge can be implemented.

In order to suppress the characteristic degradation to be caused by signal loss, high-frequency circuits need to be designed with suppressed capacitance. In particular, in large-amplitude analog signal-processing circuits that operate in frequency bands exceeding 1 GHz (such as an MMIC (Monolithic Microwave Integrated Circuit) or so forth), it is known that capacitances on an order of several tens of femtofarads affect the characteristic degradation.

Thus, if a design in which a circuit having a capacitance on an order of picofarads, such as a diode, a thyristor, a MOS circuit, or so forth, is connected as an electrostatic-discharge protection circuit, and in which a bypass circuit operates in response to input of high-voltage surges such as electrostatic discharge is employed, an increase in capacitance causes a significant problem of the characteristic degradation of the high-frequency circuits.

The inventor of the present technology focused on a case where the high-frequency circuit such as the MMIC is formed on a semiconductor by a process called an SOI process. Then, as a novel approach not disclosed in the related art, the inventor conceived an idea of implementing the bypass circuit for high-voltage surges such as electrostatic discharge by utilizing a fact that circuit elements and the silicon substrate are insulated from each other by forming an insulating film on the silicon substrate. As a result, the inventor devised, as a novel configuration, the circuit-protection impedance design in the high-frequency circuit 1 including the bypass via 6 as exemplified in Fig. 1.

For example, when the silicon substrate is employed as the base substrate 2, in general, a silicon wafer having a resistance value selected therefor can be purchased. By setting the resistance values of the silicon substrate as appropriate as described above, the impedance of the bypass path can be adjusted. With this, it is possible to easily implement the circuit-protection impedance design according to the present technology. In addition, it is also possible to easily form the bypass via by modifying a structure of a high-frequency circuit formed by the existing SOI process, and to suppress the degradation of the circuit characteristics.

As a matter of course, depending on configurations of the circuit portion 4 of the high-frequency circuit 1, conditions for implementing the circuit-protection impedance design in which the signal path is lower in the impedance for the high-frequency signals than the bypass path, and in which the signal path is higher in the impedance for the low-frequency signals than the bypass path can be stringent. However, for example, when a method of setting the resistance value of the base substrate 2 as appropriate is employed as appropriate, the present technology is applicable to a wide range.

[High-Frequency Circuit Module]

A high-frequency circuit module including the high-frequency circuit 1 according to the present technology as exemplified in Fig. 1 may be configured. For example, a module including one or more high-frequency circuits 1 may be configured as the high-frequency circuit module according to the present technology. Specifically, for example, a configuration in which the plurality of high-frequency circuits 1 is connected between the antenna 12 and the signal processing circuit 14, and the plurality of these high-frequency circuits 1 is collectively modularized may be employed. As a matter of course, other than such a configuration, a high-frequency circuit module including the single high-frequency circuit 1 is possible.

Alternatively, for example, a module including the high-frequency circuit 1 and the signal processing circuit 14 illustrated in Fig. 1 may be configured as the high-frequency circuit module according to the present technology. Note that, a specific configuration of the signal processing circuit 14 is not limited, and, for example, ICs having any configuration may be implemented.

Alternatively, the high-frequency circuit module according to the present technology may have a configuration including the antenna 12 illustrated in in Fig. 1. As a matter of course, a specific configuration of the antenna 12 is not limited.

In such a way, the high-frequency circuit module according to the present technology may have the configurations including only the one or more high-frequency circuits 1. Alternatively, the high-frequency circuit module according to the present technology may have a configuration including in either one or both any element which is electrically connected to the first terminal 7 and which outputs high-frequency signals, and any element which is electrically connected to the second terminal 9 and to which the high-frequency signals are input.

For example, the MMIC is widely utilized for implementing low noise amplifiers (LNAs), power amplifiers (PAs), band switches, Rx/Tx switches, diplexers, filters, antenna tuning, integrated passive devices (IPDs), and so forth. In this context, the high-frequency circuit according to the present technology is applicable to the implementation of these elements.

In addition, MMIC modules incorporating a plurality of MMICs are also utilized in various fields. The high-frequency circuit according to the present technology is applicable also to the implementation of the various MMIC modules.

For example, 5G applications using the MMICs are widely utilized in categories such as mobile communications and satellite communications in the network field. In addition, in the device field, the 5G applications are widely utilized in categories such as smartphones, IoT devices (such as wearable devices, drones, and robots), and mobile base stations. For example, the MMICs are utilized in in-vehicle radars, wireless communication modules such as Wi-Fi modules, and communication modules for millimeter-wave 5G base stations.

Further, for example, the 5G applications using the MMICs are utilized for implementing, for example, high-speed downloads of content such as movies, remote control of robots, and simultaneous connection of a large number of devices such as smartphones, PCs, and various sensors. Still further, the 5G applications using the MMICs are utilized for implementing V2V (Vehicle-to-Vehicle communication), V2I (Vehicle-to-Infrastructure communication), V2P (Vehicle-to-Pedestrian communication), V2B (Vehicle-to-Bicycle communication), V2N (Vehicle-to-Network communication), and so forth.

Yet further, the 5G applications using the MMICs are utilized for implementing communication systems such as HAPS (High Altitude Platform Station).

The high-frequency circuit according to the present technology is applicable to various high-frequency circuits, various high-frequency circuit modules, and various high-frequency circuit devices that are utilized in the above-described various fields.

<Other Embodiments>

The present technology is not limited the embodiment described hereinabove, and various other embodiments may be implemented.

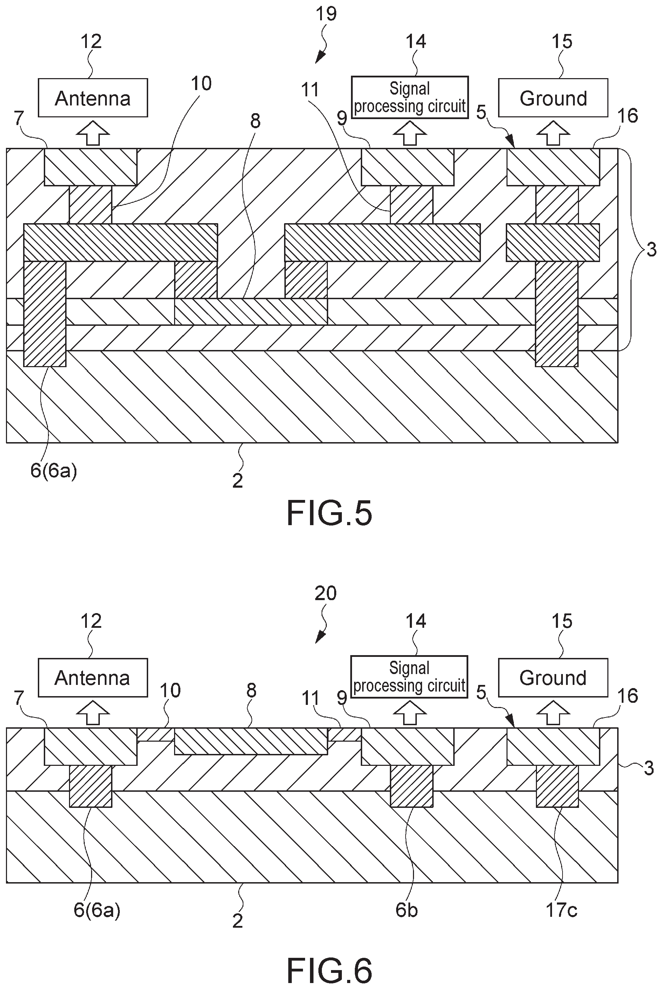

Fig. 5 and Fig. 6 are schematic views illustrating other examples of the configuration of the high-frequency circuit according to the present technology. A high-frequency circuit 19 illustrated in Fig. 5 includes only the first bypass via 6a that electrically connects the first terminal 7 and the base substrate 2 to each other, and that forms the bypass path for the low-frequency signals which are input to the first terminal 7. In other words, the bypass via 6 does not include the second bypass via 6b that electrically connects the second terminal 9 and the base substrate 2 to each other, and that forms the bypass path for the low-frequency signals which are input to the second terminal 9.

In such a way, only the first bypass via 6a may be formed. As a matter of course, the first bypass via 6a may be omitted, and only the second bypass via 6b may be formed. For example, depending on design of the high-frequency circuit 1 and the high-frequency circuit module, there can be terminals that high-voltage surges such as electrostatic discharge are likely to enter, and terminals that high-voltage surges are unlikely to enter. In other words, the likelihood of the entry of high-voltage surges may vary from terminal to terminal.

For example, the bypass via 6 is formed preferentially in the terminal that high-voltage surges such as electrostatic discharge are likely to enter. This makes it possible to efficiently achieve an effect of circuit protection against high-voltage surges.

The high-frequency circuit 1 and the high-frequency circuit module may include the bypass vias 6 for all the terminals (first terminal 7 / second terminal 9). Meanwhile, the bypass via 6 may be formed for only one of the terminals. In other words, when the bypass via 6 is formed for at least one of the terminals, the high-frequency circuit and the high-frequency circuit module according to the present technology can be implemented.

In a high-frequency circuit 20 illustrated in in Fig. 6, the first bypass via 6a is connected to the first terminal 7. In addition, the second bypass via 6b is connected to the second terminal 9. Similarly, the ground via 17c is connected to the ground terminal 16. Such a configuration may be employed.

As a matter of course, there can be a configuration obtained by combining the configuration illustrated in in Fig. 1 in which the bypass vias 6 are connected to the connection members (first connection member 10 / second connection member 11), and the configuration illustrated in in Fig. 6 in which the bypass vias 6 are connected to the terminals (first terminal 7 / second terminal 9).

The configurations of the high-frequency circuits, the high-frequency circuit module, the bypass vias, the circuit portion, the circuit element, the ground connection portion, and so forth described with reference to the drawings are merely those in one embodiment, and may be freely modified without departing from the gist of the present technology. In other words, any other configuration for implementing the present technology may be employed.

Herein, for ease of understanding of the description, terms such as "substantially," "almost," and "approximately" are used as appropriate. Meanwhile, strict distinctions are not defined as to whether or not these terms such as "substantially," "almost," and "approximately" are used.

In other words, herein, concepts that define, for example, shapes, sizes, positional relationships, and states, such as "center," "central," "uniform," "equal," "same," "orthogonal," "parallel," "symmetric," "extending," "axial," "columnar," "tubular," "ring-shaped," and "annular," are interpreted as concepts that encompass, for example, "substantially at the center," "substantially central," "substantially uniform," "substantially equal," "substantially the same," "substantially orthogonal," "substantially parallel," "substantially symmetric," "substantially extending," "substantially axial," "substantially columnar," "substantially tubular," "substantially ring-shaped," and "substantially annular."

For example, states within a predetermined range (such as a range of $\pm 10\%$) of, for example, "perfectly at the center," "perfectly central," "perfectly uniform," "perfectly equal," "perfectly the same," "perfectly orthogonal," "perfectly parallel," "perfectly symmetric," "perfectly extending," "perfectly axial," "perfectly columnar," "perfectly tubular," "perfectly ring-shaped," and "perfectly annular" are also encompassed.

Thus, even without the terms such as "substantially," "almost," and "approximately," concepts to be expressed with these commonly-used qualifiers such as "substantially," "almost," and "approximately" can be encompassed. Conversely, the states expressed with the qualifiers such as "substantially," "almost," and "approximately" do not necessarily exclude perfectly exact states.

Herein, comparative expressions such as "larger than A" and "smaller than A" are expressions that comprehensively encompass both concepts which include equality with A and concepts which exclude the equality with A. For example, "larger than A" is not limited to the cases that exclude the equality with A, and encompasses "A or more." Similarly, "smaller than A" is not limited to "less than A," and encompasses "A or less."

When implementing the present technology, it is at least necessary to employ specific settings or so forth as appropriate from the concepts encompassed in "larger than A" and "smaller than A" so that the effects described above are achieved.

Of the features according to the present technology described hereinabove, at least two of the features may be combined with each other. In other words, the various features described respectively in the different embodiments may be freely combined with each other. In addition, the various effects described hereinabove are merely examples, and hence are not limited thereto. Other effects may be achieved.

Note that, the present technology may employ configurations as follows.

(1) A high-frequency circuit, including:

a base substrate which is electrically connected to a ground, and which is made of a semiconductor material;
an insulating layer which is provided to the base substrate;
a first terminal which is provided to the insulating layer, and to which a high-frequency signal in a predetermined high-frequency band is input;
a circuit element which is provided to the insulating layer, and which is electrically connected to the first terminal;
a second terminal which is provided to the insulating layer, which is electrically connected to the circuit element, and from which the high-frequency signal that is input to the first terminal and that flows through the circuit element is output; and
a bypass via which electrically connects the first terminal or the second terminal and the base substrate to each other, and which forms a bypass path for a low-frequency signal in a frequency band lower than the predetermined high-frequency band.

(2) The high-frequency circuit according to (1), in which
the high-frequency circuit includes, as the bypass via, at least one of

a first bypass via which electrically connects the first terminal and the base substrate to each other, and which forms a bypass path for the low-frequency signal that is input to the first terminal, or
a second bypass via which electrically connects the second terminal and the base substrate to each other, and which forms a bypass path for the low-frequency signal that is input to the second terminal.

(3) The high-frequency circuit according to (2), in which

the high-frequency circuit includes the first bypass via as the bypass via,
for the high-frequency signal, an impedance of a path from the first terminal to the second terminal through the circuit element is lower than an impedance of a path from the first terminal to the ground through the first bypass via and the base substrate, and
for the low-frequency signal, the impedance of the path from the first terminal to the second terminal through the circuit element is higher than the impedance of the path from the first terminal to the ground through the first bypass via and the base substrate.

(4) The high-frequency circuit according to (2) or (3), in which

the high-frequency circuit includes the second bypass via as the bypass via,
for the high-frequency signal, an impedance of a path from the second terminal to the first terminal through the circuit element is lower than an impedance of a path from the second terminal to the ground through the second bypass via and the base substrate, and
for the low-frequency signal, the impedance of the path from the second terminal to the first terminal through the circuit element is higher than the impedance of the path from the second terminal to the ground through the second bypass via and the base substrate.

(5) The high-frequency circuit according to any one of (3) to (5), in which
the high-frequency circuit includes both the first bypass via and the second bypass via.
(6) The high-frequency circuit according to any one of (1) to (5), in which
the first terminal, the circuit element, and the second terminal are provided to the insulating layer to be separated from the base substrate.
(7) The high-frequency circuit according to any one of (1) to (6), in which
the bypass via extends from the insulating layer to the base substrate, and is connected to the base substrate.
(8) The high-frequency circuit according to any one of (1) to (7), in which

> the second terminal functions also as a terminal to which the high-frequency signal is input, and
> the first terminal functions also as a terminal from which the high-frequency signal that is input to the second terminal and that flows through the circuit element is output.

(9) The high-frequency circuit according to any one of (1) to (8), in which
the predetermined high-frequency band is a frequency band of 1 GHz or higher.
(10) The high-frequency circuit according to any one of (1) to (9), in which
the circuit element is a transistor.
(11) The high-frequency circuit according to any one of (1) to (10), in which
the base substrate is a silicon substrate.
(12) The high-frequency circuit according to any one of (1) to (11), further including

> a first connection member which is provided to the insulating layer, and which electrically connects the first terminal and the circuit element to each other, in which
> the first bypass via electrically connects the first connection member and the base substrate to each other.

(13) The high-frequency circuit according to any one of (1) to (12), further including

> a second connection member which is provided to the insulating layer, and which electrically connects the second terminal and the circuit element to each other, in which
> the second bypass via electrically connects the second connection member and the base substrate to each other.

(14) The high-frequency circuit according to any one of (1) to (13), further including:

> a ground terminal which is electrically connected to the ground; and
> a ground connection portion which electrically connects the ground terminal and the base substrate to each other.

(15) A high-frequency circuit module including one or more high-frequency circuits, the one or more high-frequency circuits each including:

> a base substrate which is electrically connected to a ground, and which is made of a semiconductor material;
> an insulating layer which is provided to the base substrate;
> a first terminal which is provided to the insulating layer, and to which a high-frequency signal in a predetermined high-frequency band is input;
> a circuit element which is provided to the insulating layer, and which is electrically connected to the first terminal;
> a second terminal which is provided to the insulating layer, which is electrically connected to the circuit element, and from which the high-frequency signal that is input to the first terminal and that flows through the circuit element is output; and
> a bypass via which electrically connects the first terminal or the second terminal and the base substrate to each other, and which forms a bypass path for a low-frequency signal in a frequency band lower than the predetermined high-frequency band.

Reference Signs List

Z1        impedance of signal path
Z2        impedance of bypass path
1, 19, 20    high-frequency circuit

2 base substrate
3 insulating layer
4 circuit portion
5 ground connection portion
6 bypass via
6a first bypass via
6b second bypass via
7 first terminal
8 circuit element
9 second terminal
10 first connection member
11 second connection member
16 ground terminal
17 ground connection member

**Claims**

1. A high-frequency circuit, comprising:

   a base substrate which is electrically connected to a ground, and which is made of a semiconductor material;
   an insulating layer which is provided to the base substrate;
   a first terminal which is provided to the insulating layer, and to which a high-frequency signal in a predetermined high-frequency band is input;
   a circuit element which is provided to the insulating layer, and which is electrically connected to the first terminal;
   a second terminal which is provided to the insulating layer, which is electrically connected to the circuit element, and from which the high-frequency signal that is input to the first terminal and that flows through the circuit element is output; and
   a bypass via which electrically connects the first terminal or the second terminal and the base substrate to each other, and which forms a bypass path for a low-frequency signal in a frequency band lower than the predetermined high-frequency band.

2. The high-frequency circuit according to claim 1, wherein
   the high-frequency circuit includes, as the bypass via, at least one of

   a first bypass via which electrically connects the first terminal and the base substrate to each other, and which forms a bypass path for the low-frequency signal that is input to the first terminal, or
   a second bypass via which electrically connects the second terminal and the base substrate to each other, and which forms a bypass path for the low-frequency signal that is input to the second terminal.

3. The high-frequency circuit according to claim 2, wherein

   the high-frequency circuit includes the first bypass via as the bypass via,
   for the high-frequency signal, an impedance of a path from the first terminal to the second terminal through the circuit element is lower than an impedance of a path from the first terminal to the ground through the first bypass via and the base substrate, and
   for the low-frequency signal, the impedance of the path from the first terminal to the second terminal through the circuit element is higher than the impedance of the path from the first terminal to the ground through the first bypass via and the base substrate.

4. The high-frequency circuit according to claim 2, wherein

   the high-frequency circuit includes the second bypass via as the bypass via,
   for the high-frequency signal, an impedance of a path from the second terminal to the first terminal through the circuit element is lower than an impedance of a path from the second terminal to the ground through the second bypass via and the base substrate, and
   for the low-frequency signal, the impedance of the path from the second terminal to the first terminal through the circuit element is higher than the impedance of the path from the second terminal to the ground through the second bypass via and the base substrate.

5. The high-frequency circuit according to claim 3, wherein
the high-frequency circuit includes both the first bypass via and the second bypass via.

6. The high-frequency circuit according to claim 1, wherein
the first terminal, the circuit element, and the second terminal are provided to the insulating layer to be separated from the base substrate.

7. The high-frequency circuit according to claim 1, wherein
the bypass via extends from the insulating layer to the base substrate, and is connected to the base substrate.

8. The high-frequency circuit according to claim 1, wherein

the second terminal functions also as a terminal to which the high-frequency signal is input, and
the first terminal functions also as a terminal from which the high-frequency signal that is input to the second terminal and that flows through the circuit element is output.

9. The high-frequency circuit according to claim 1, wherein
the predetermined high-frequency band is a frequency band of 1 GHz or higher.

10. The high-frequency circuit according to claim 1, wherein
the circuit element is a transistor.

11. The high-frequency circuit according to claim 1, wherein
the base substrate is a silicon substrate.

12. The high-frequency circuit according to claim 1, further comprising

a first connection member which is provided to the insulating layer, and which electrically connects the first terminal and the circuit element to each other, wherein
the first bypass via electrically connects the first connection member and the base substrate to each other.

13. The high-frequency circuit according to claim 1, further comprising

a second connection member which is provided to the insulating layer, and which electrically connects the second terminal and the circuit element to each other, wherein
the second bypass via electrically connects the second connection member and the base substrate to each other.

14. The high-frequency circuit according to claim 1, further comprising:

a ground terminal which is electrically connected to the ground; and
a ground connection portion which electrically connects the ground terminal and the base substrate to each other.

15. A high-frequency circuit module comprising one or more high-frequency circuits, the one or more high-frequency circuits each including:

a base substrate which is electrically connected to a ground, and which is made of a semiconductor material;
an insulating layer which is provided to the base substrate;
a first terminal which is provided to the insulating layer, and to which a high-frequency signal in a predetermined high-frequency band is input;
a circuit element which is provided to the insulating layer, and which is electrically connected to the first terminal;
a second terminal which is provided to the insulating layer, which is electrically connected to the circuit element, and from which the high-frequency signal that is input to the first terminal and that flows through the circuit element is output; and
a bypass via which electrically connects the first terminal or the second terminal and the base substrate to each other, and which forms a bypass path for a low-frequency signal in a frequency band lower than the predetermined high-frequency band.

FIG.1

FIG.2

FIG.3

FIG. 4

FIG.5

FIG.6

**EP 4 780 164 A1**

## INTERNATIONAL SEARCH REPORT

| International application No. |
|---|
| **PCT/JP2024/028310** |

**A. CLASSIFICATION OF SUBJECT MATTER**

*H01L 27/04*(2006.01)i; *H01L 21/822*(2006.01)i
FI: H01L27/04 H

According to International Patent Classification (IPC) or to both national classification and IPC

**B. FIELDS SEARCHED**

Minimum documentation searched (classification system followed by classification symbols)

H01L27/04; H01L21/822

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2018/173522 A1 (MURATA MANUFACTURING CO., LTD.) 27 September 2018 (2018-09-27) | 1-15 |
| A | WO 2018/168173 A1 (MURATA MANUFACTURING CO., LTD.) 20 September 2018 (2018-09-20) | 1-15 |
| A | JP 2007-173793 A (KABUSHIKI KAISHA TOSHIBA) 05 July 2007 (2007-07-05) | 1-15 |
| A | JP 2012-521645 A (INTERNATIONAL BUSINESS MACHINES CORPORATION) 13 September 2012 (2012-09-13) | 1-15 |
| A | JP 2013-073993 A (SEMICONDUCTOR COMPONENTS INDUSTRIES LLC) 22 April 2013 (2013-04-22) | 1-15 |

☐ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **27 September 2024** | **15 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
**Information on patent family members**

International application No.

**PCT/JP2024/028310**

| Patent document cited in search report | | | Publication date (day/month/year) | Patent family member(s) | | | Publication date (day/month/year) |
|---|---|---|---|---|---|---|---|
| WO | 2018/173522 | A1 | 27 September 2018 | US | 2019/0214815 | A1 | |
| | | | | CN | 209266387 | U | |
| WO | 2018/168173 | A1 | 20 September 2018 | US | 2019/0123040 | A1 | |
| | | | | CN | 209104139 | U | |
| JP | 2007-173793 | A | 05 July 2007 | US | 2007/0120193 | A1 | |
| | | | | CN | 1976028 | A | |
| JP | 2012-521645 | A | 13 September 2012 | US | 2010/0244187 | A1 | |
| | | | | EP | 2412023 | A1 | |
| | | | | TW | 201108393 | A | |
| | | | | CN | 102362349 | A | |
| JP | 2013-073993 | A | 22 April 2013 | US | 2013/0075865 | A1 | |
| | | | | CN | 103077945 | A | |
| | | | | TW | 201324729 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019103125 A
- JP 2015050455 A